# EUROPEAN PATENT APPLICATION

(11) **EP 3 059 842 A1**
(43) Date of publication of application: **24.08.2016**
(21) Application number: 15275040.2
(22) Date of filing: 18.02.2015
(51) Int. Cl.: H02M 1/36, H03K 17/082

(54) **Method of protecting a semiconductor device**

(71) Applicant: ALSTOM Technology Ltd, 5400 Baden (CH)
(72) Inventor: OUTRAM, John Lewis, Stone Staffordshire ST15 8YD (GB); GREGOIRE, Jerome, Birmingham B2 5RS (GB)
(74) Representative: Potter Clarkson LLP

(57) **Abstract**

It is desirable to protect a semiconductor device from a fault current so as to prevent damage thereof.

A method of protecting at least one semiconductor device (10, 136) from a fault current that exceeds a safety current threshold (I_{S}) comprises the step of operating the or each semiconductor device (10, 136) in a saturated state. The method also includes the step of monitoring a current (I_{C}) through the or each semiconductor device (10, 136) in the saturated state. Moreover, the method includes the step of turning off the or each semiconductor device (10, 136) from the saturated state when the current (I_{C}) through the or each semiconductor device (10, 136) exceeds the safety current threshold (I_{S}) and before the current (I_{C}) through the or each semiconductor device (10, 136) reaches a current level (22a), 22b), 22c)) which allows the or each semiconductor device to enter a desaturated state.

## Description

This invention relates to a method of protecting at least one semiconductor device from a fault current that exceeds a safety current threshold, and a semiconductor device protection apparatus.

In power transmission networks alternating current (AC) power is typically converted to direct current (DC) power for transmission via overhead lines and/or undersea cables. This conversion removes the need to compensate for the AC capacitive load effects imposed by the transmission line or cable, and thereby reduces the cost per kilometre of the lines and/or cables. Conversion from AC to DC thus becomes cost-effective when power needs to be transmitted over a long distance.

Voltage source converters are used to convert between AC power and DC power. Semiconductor devices, such as insulated gate bipolar transistors (IGBTs), are a key component of voltage source converters.

During normal operation of a voltage source converter, a semiconductor device will operate in a blocked state, preventing current therethrough, or in a saturated state with a normal operating current flowing therethrough. However, in the event of a fault, an elevated fault current flows through the semiconductor device. Such a fault current may result in the semiconductor device becoming damaged and, in some instances, the semiconductor device may ultimately need replacing.

According to a first aspect of the invention there is provided a method of protecting at least one semiconductor device from a fault current that exceeds a safety current threshold, the method comprising the steps of:
operating the or each semiconductor device in a saturated state;
monitoring a current through the or each semiconductor device in the saturated state;
turning off the or each semiconductor device from the saturated state when the current through the or each semiconductor device exceeds the safety current threshold and before the current through the or each semiconductor device reaches a current level which allows the or each semiconductor device to enter a desaturated state.

The aforementioned method turns off a semiconductor device such that the semiconductor device does not enter the desaturated state before it is turned off.

It will be understood that turning off the semiconductor device in the context of the invention means actively reducing a control voltage to below an operating voltage of the semiconductor device. Although such active turn-off subsequently results in the semiconductor device entering a desaturated state after turn-off, it will be appreciated that such entry into the desaturated state after turn-off is distinct from the semiconductor device in the saturated state being allowed to naturally enter the desaturated state due to a fault current.

A semiconductor device is normally operated at an industry standard control voltage which controls a current flowing through the semiconductor device. When the current flowing through the semiconductor device experiences a relatively small opposing voltage, the semiconductor device is in a saturated state, which means that the semiconductor device is considered fully turned on. The semiconductor device remains in its saturated state when the current flowing therethrough remains below a desaturation current level, which is typically 4 to 6 times the semiconductor device's rated current.

In the event that the current flowing through the semiconductor device exceeds the desaturation current level, i.e. due to a fault current, the relatively small opposing voltage cannot be maintained and thus the voltage across the semiconductor device begins to steeply rise with only a small further increase in current. In this instance, the semiconductor device is considered to have entered a desaturated state.

Conventionally, allowing the semiconductor device to enter the desaturated state is typically utilised as a fault protection method since the desaturated state of the semiconductor device tends to limit the fault current flowing through the semiconductor device. Meanwhile the steeply rising voltage across the semiconductor device following entry into the desaturated state is readily detectable so as to indicate that there is a fault current flowing therethrough.

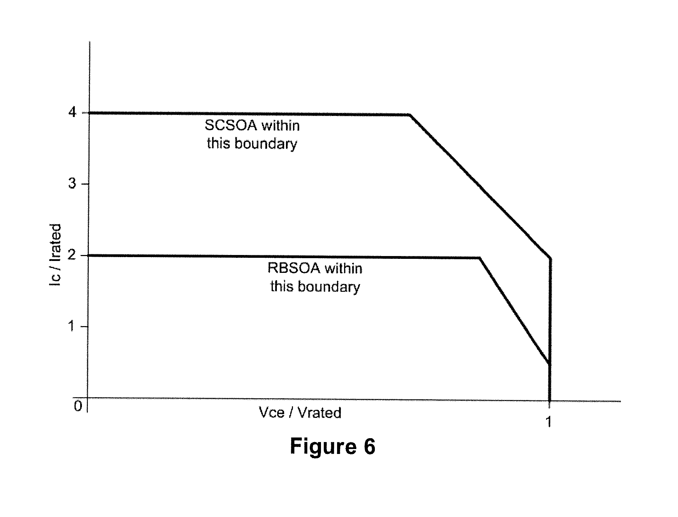

As an example, the semiconductor device in the form of an IGBT may be operating at an industry standard control voltage V_{GE} of 15V. Although the control voltage will remain at 15V once the semiconductor device is desaturated until turn-off, a voltage V_{CE} across the semiconductor device will rise towards a DC capacitor voltage when the semiconductor device has entered the desaturated state. Typically, desaturation can be detected by monitoring the voltage across the semiconductor at a threshold between 50V and 150V. Once the semiconductor device has entered the desaturated state such that the fault current has been limited and the steeply rising voltage has been detected, the semiconductor device is then switched off. Normally, so as to avoid potential damage of the semiconductor device, it is turned off within 10µs of the desaturated state being detected. At the instant the fault occurs, V_{CE} = 0 and I_{C} has a value usually between 0 and rated current; at the end of turn off I_{C} = 0 and V_{CE} has a value usually between 0 and rated voltage. To avoid potential damage, the trajectory of V_{CE} and I_{C} must stay within the short circuit safe operating area (SCSOA), as shown in Figure 6, and complete its transit within 10 µs. In this conventional way, it is the desaturated state of the semiconductor device which provides a means of fault detection, and ultimately fault protection, of the semiconductor device.

Operating the semiconductor device at a control voltage higher than the industry standard control voltage results in the aforementioned conventional desaturation protection method being ineffective such that the semiconductor device would be vulnerable to damage due to a fault current. On the other hand, operating the semiconductor device at a control voltage lower than the industry standard control voltage results in higher conduction losses.

Monitoring a current through the semiconductor device provides a means of detecting a fault current through the semiconductor device to enable timely turn-off of the or each semiconductor device in accordance with the invention, thereby protecting the semiconductor device from the fault current.

Monitoring the current and subsequently turning off the semiconductor device from the saturated state upon detection of a current exceeding a safety current threshold (i.e. the fault current) in accordance with the invention permits the semiconductor device to be operated in the saturated state at a control voltage that is higher than an industry standard control voltage. Operating the semiconductor device in the saturated state at a control voltage that is higher than the industry standard control voltage beneficially reduces conduction losses associated with the semiconductor device.

The method according to the first aspect of the invention therefore maintains protection of the semiconductor device by turning it off from the saturated state when the current flowing therethrough exceeds the safety current threshold and before the current through the semiconductor device reaches a current level which allows the semiconductor device to enter the desaturated state, while minimising conduction losses of the semiconductor device by operating it at a control voltage higher than the industry standard control voltage.

The semiconductor device may an IGBT, or may instead be a MOSFET or a SiC MOSFET.

Preferably, the step of turning off the or each semiconductor device may be carried out in direct response to the current through the or each semiconductor device exceeding the safety current threshold.

In this way, the semiconductor device is turned off immediately after the current through the semiconductor device exceeds the safety current threshold. More particularly, the semiconductor device is turned off within a time period corresponding to a V_{CE}/I_{C} transit within the SCSOA of the semiconductor device, which may be 10µs from the current exceeding the safety current threshold.

In contrast, in an alternative method, when the current through the semiconductor device exceeds the safety current threshold, the semiconductor device may instead be controlled so as to first reduce the fault current and then to switch off the semiconductor device. Reducing the fault current may be carried out by allowing the semiconductor device to enter the desaturated state and maintaining this state for a period of time, thus permitting the reduction of the fault current flowing through the semiconductor device. Such a method may typically be utilised in the situation where the fault current through the semiconductor device is such that the semiconductor device cannot be turned off. Such an alternative process is however more complex and thus less reliable than the process of turning off the semiconductor device according to the invention.

Optionally, the step of turning off the or each semiconductor device may be carried out when the current through the or each semiconductor device is rising in magnitude.

The current through the semiconductor device will rise in magnitude towards a peak current because of a fault current. The current, as it is rising in magnitude, will first exceed the safety current threshold and the semiconductor device will be turned off before the current is able to reach a peak current, thereby reliably protecting the semiconductor device.

In contrast, in an alternative method, if the semiconductor device is allowed to enter the desaturated state, the current through the semiconductor device would rise in magnitude towards a peak current and then begin to fall due to the effect of the desaturated state of the semiconductor. The semiconductor device would therefore be subsequently turned off when the current through the semiconductor device is falling in magnitude, and more particularly, falling in magnitude from a peak current. The current through the semiconductor device rising in magnitude may damage the semiconductor device if the peak current is reached.

Operating the or each semiconductor device in a saturated state may include operating the or each semiconductor device at a control voltage above that at which a short-circuit safe operating area of the semiconductor device is defined.

More specifically, operating the or each semiconductor device in a saturated state may include operating the or each semiconductor device in the form of an IGBT at a control voltage above 15V.

Since operating the IGBT at a control voltage above 15V results in a lower voltage across the IGBT for a given current, the conduction losses associated with the IGBT are reduced.

In an embodiment of the invention, monitoring a current through the or each semiconductor device may include monitoring one or more of:
a saturated voltage drop across the or each semiconductor device;
a voltage drop across a resistor connected in series with the or each semiconductor device as a shunt; or
a magnetic field generated by the current through the or each semiconductor device.

Optionally, the or each semiconductor device may include a gate terminal, a collector terminal and an emitter terminal, and optionally wherein the or each semiconductor device is an IGBT.

The collector and emitter terminals permit current to flow through the semiconductor device when the semiconductor device is in the saturated state. Meanwhile the gate terminal controls the aforementioned flow of current. It is therefore the current flowing from the collector to the emitter that is monitored in the method of the invention.

The gate terminal may also be known as a base terminal and the collector terminal may also be known as a drain or anode terminal. Meanwhile the emitter terminal may instead be known as a source or cathode terminal.

Moreover, the or each semiconductor device may be operated in the saturated mode at a control voltage, the control voltage in the form of a gate-emitter voltage applied across the gate and emitter terminals of the or each semiconductor device.

In an embodiment of the invention the or each semiconductor device may form part of an electrical module, wherein the current through the or each semiconductor device exceeding the safety current threshold is caused by a fault that occurs external to the electrical module.

An example of a fault that may occur external to the electrical module is one which occurs on an external electrical device which is electrically coupled to the electrical module, a breakdown of electrical insulation of the external electrical device, or a fault resulting from a lightning strike.

More specifically, in an embodiment of the invention wherein the semiconductor device forms part of a sub-module within a voltage source converter, an external fault may be a fault that occurs external to the sub-module.

In any event, the ability to turn off the semiconductor device in the event of an external fault is particularly important if there are a number of semiconductor devices forming part of an assembly since such an external fault can typically affect all of the semiconductor devices in the assembly. Thus, it is desirable that each of the semiconductor devices can be turned off, within its SCSOA, to protect each of the semiconductor devices from damage.

Moreover, since the method of the invention permits the or each semiconductor device to be operated in the saturated state at a control voltage higher than the industry standard control voltage, the desaturation current level is higher than that of the semiconductor device when it is operated at a control voltage equal to (or lower than) the industry standard control voltage. Such a higher desaturation current level permits some high current pulses, e.g. a short current pulse resulting from an external fault such as a lightning strike, to be tolerated by the semiconductor device without damaging the device or interrupting its operation by the device entering the desaturated state.

In contrast, a semiconductor device which is operated in the saturated state at the industry standard control voltage has a lower desaturation current level such that a current pulse arising from an external fault (for example, a lightning strike) may result in the semiconductor device entering the desaturated state, thus interrupting the operation of the semiconductor device.

The method of the invention may further include the steps of:
turning on the or each semiconductor device at a first control voltage;
monitoring a current through or a voltage across the or each semiconductor device for a predefined time period to determine whether the or each semiconductor device at the first control voltage enters a desaturated state;
after the predefined time period lapses, increasing the control voltage of the or each semiconductor device from the first control voltage to a higher, second control voltage in order to thereby carry out the step of operating the or each semiconductor device in a saturated state.

Upon turn-on of the or each semiconductor device at the first control voltage (e.g. the industry-standard control voltage of 15 V for an IGBT), a short-circuit may occur. Under such circumstances, the or each semiconductor device is allowed within the predefined time period to enter the desaturated state to limit any fault current flowing therethrough. However, if the predefined time period lapses and the or each semiconductor device has not entered the desaturated state, the short-circuit has not occurred. Hence, the control voltage can then be increased to the higher, second control voltage at which the or each semiconductor device is operated in the saturated state. Subsequently the or each semiconductor device is protected by way of the aforementioned turn-off of the or each semiconductor device such that the or each semiconductor device does not enter the desaturated state before it is turned off.

In circumstances (e.g. an internal fault) where the fault current rises too quickly, it may not be possible for the method of the invention to permit turn-off of the or each semiconductor device such that the or each semiconductor device does not enter the desaturated state before it is turned off. Under such circumstances, the or each semiconductor device may enter the desaturated state.

The method of the invention may further include the step of monitoring a current through or a voltage across the or each semiconductor device to detect whether the or each semiconductor device has entered a desaturated state. This provides a back-up protection step in which the detection of the or each semiconductor device entering a desaturated state can be used as a trigger to initiate other protection mechanisms, such as closure of an associated bypass switch. Whilst this does not guarantee the safety of the or each semiconductor device, other associated devices may be protected by the initiation of the other protection mechanisms.

Optionally, the method may include the steps of:
operating a plurality of semiconductor devices in a saturated state;
monitoring a current through each of the plurality of semiconductor devices in the saturated state;
turning off at least one of the plurality of semiconductor devices from the saturated state when the current through the or each semiconductor device exceeds the safety current threshold and before the current through the at least one semiconductor device reaches a current level which allows the at least one semiconductor device to enter a desaturated state.

An electrical assembly, e.g. a voltage source converter, may include many thousands of semiconductor devices. It is therefore desirable to be able to protect each of the semiconductor devices from a fault, as necessary, since otherwise the cost and time required to replace or repair damaged semiconductor devices would be high.

Moreover, it is desirable to reduce the conduction losses of the semiconductor devices by operating them at a control voltage higher than an industry standard control voltage since such reduction is multiplied by many thousands, and will thus result in large reduction of the overall conduction losses of the electrical assembly.

Preferably, the method of the invention may include the step of allowing the current through at least one other of the plurality of semiconductor devices in the saturated state to reach a current level which allows the or each other semiconductor device to enter the desaturated state.

It may be desirable under certain circumstances to protect some semiconductor devices of the electrical assembly by the desaturation protection method, i.e. allowing the semiconductor device to enter the desaturated state thus limiting a fault current, in the event of a specific type of fault. Alternatively, it may be desirable to protect some other semiconductor devices by turning them off before they enter the desaturated state in the event of a different type of fault. It is therefore desirable to be able to select different semiconductor devices to be protected via one or the other of the aforementioned protection methods such that conduction losses and protection of the plurality of semiconductor devices are optimised for a particular application.

Thus, the provision of allowing the current through the or each other semiconductor device to reach a level which allows the or each other semiconductor device to enter the desaturated state permits the method of the invention to be adapted depending on the type of fault and/or the position of the semiconductor device within the electrical assembly.

According to a second aspect of the invention there is provided a semiconductor device protection apparatus comprising:
at least one semiconductor device;
a control unit being configured to operate the or each semiconductor device in a saturated state; and
a monitoring device being in communication with the control unit, the monitoring device being configured to monitor a current through the or each semiconductor device in the saturated state and communicate the monitored current to the control unit,
wherein the control unit is further configured to turn off the or each semiconductor device from the saturated state when the current through the or each semiconductor device exceeds a safety current threshold and before the current through the or each semiconductor device reaches a current level which allows the or each semiconductor device to enter a desaturated state.

The semiconductor device protection apparatus shares the features and benefits associated with the first aspect of the invention, as described hereinabove.

Optionally, the semiconductor device protection apparatus may include:
a plurality of semiconductor devices;
a control unit being configured to operate each of the plurality of semiconductor devices in a saturated state; and
a monitoring device being in communication with the control unit, the monitoring device being configured to monitor a current through each of the plurality of semiconductor devices in the saturated state and communicate the monitored current to the control unit,
wherein the control unit is further configured to turn off at least one of the plurality of semiconductor devices from the saturated state when the current through the at least one semiconductor device exceeds a safety current threshold and before the current through the at least one semiconductor device reaches a current level which allows the at least one semiconductor device to enter a desaturated state.

The control unit of the semiconductor device protection apparatus may additionally be configured to allow the current through at least one other of the plurality of semiconductor devices in the saturated state to reach a current level which allows the or each other semiconductor device to enter the desaturated state.

There now follows a brief description of preferred embodiments of the invention, by way of non-limiting examples, with reference to the accompanying drawings in which:
Figure 1 shows a schematic view of a semiconductor device that is protected from a fault current that exceeds a safety current threshold according to the invention;
Figure 2 shows a graph that illustrates various voltage profiles associated with the semiconductor device of Figure 1 being operated at different control voltages in a saturated and desaturated state;
Figure 3 shows, in graphical form, the voltage and current profiles associated with the semiconductor device of Figure 1 as the current through the semiconductor device exceeds a safety current threshold;
Figure 4 shows a plurality of semiconductor devices that form part of an electrical assembly that are protected from a fault current that exceeds a safety current threshold according to the invention;
Figure 5a) shows an example of a sub-module of the electrical assembly shown in Figure 4;
Figure 5b) shows another example of a sub-module of the electrical assembly shown in Figure 4; and
Figure 6 illustrates, in graphical form, the short-circuit safe operating area (SCSOA) and the reverse bias safe operating area (RBSOA) for an IGBT.

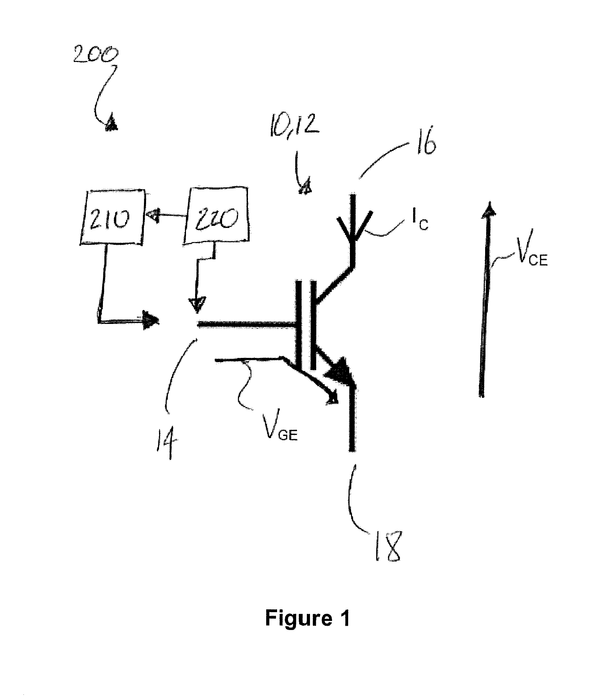

A semiconductor device 10 is shown in Figure 1.

The semiconductor device 10 is an insulated gate bipolar transistor (IGBT) 12 with a gate terminal 14, a collector terminal 16 and an emitter terminal 18.

The collector and emitter terminals 16, 18 permit a collector-emitter current I_{C} to flow through the IGBT 12. An opposing collector-emitter voltage V_{CE} is present across the collector and emitter terminals 16, 18.

Meanwhile, in use, a gate-emitter voltage V_{GE} is applied across the gate and emitter terminals 14, 18. The gate-emitter voltage V_{GE} acts as a control voltage which controls the flow of collector-emitter current I_{C} through the IGBT 12.

In other embodiments of the invention (not shown), the semiconductor device 10 may instead be a MOSFET.

In a normal operating mode, the IGBT 12 is operated in a saturated state at a gate-emitter voltage V_{GE} that is higher than an industry standard control voltage. In this embodiment, the industry standard control voltage is 15V, however, the industry standard control voltage may have a different value.

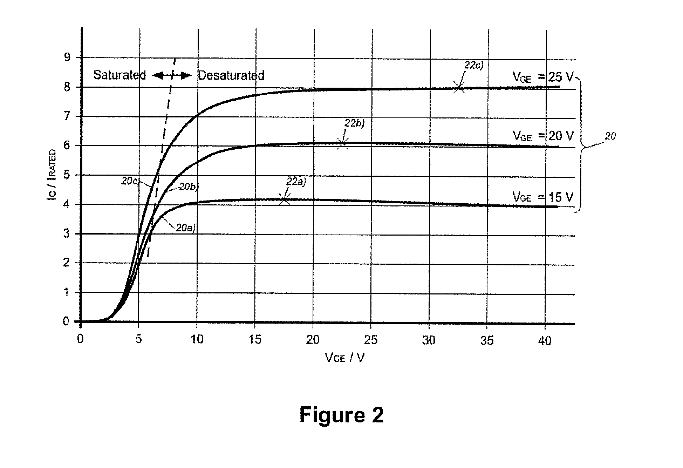

Figure 2 illustrates collector-emitter voltage profiles 20 of the IGBT 12 being operated at a gate-emitter voltage V_{GE} higher than or equal to the industry standard control voltage. More specifically, Figure 2 shows first, second, and third collector-emitter voltage profiles 20a), 20b), 20c) of the IGBT 12 being operated at gate-emitter voltages V_{GE} of 15V, 20V and 25V, respectively.

The gate-emitter voltage V_{GE} permits a collector-emitter current I_{C} to flow through the IGBT 12 in response to a collector-emitter voltage V_{CE} being applied across the collector-emitter terminals 16, 18. As V_{CE} rises from 0, at first, I_{C} increases slowly, then more and more rapidly, before becoming a substantially straight-line relationship. Over the range defined by the straight-line relationship or any lower value of V_{CE}, the IGBT 12 is considered to be in a saturated state, as indicated in Figure 2, and is therefore fully turned on.

At the end of the straight-line relationship, the increase in current Ic reduces as the Vce continues to increase, as indicated by the curve of the voltage profiles 20 in Figure 2.This is considered the onset of the desaturated state of the IGBT 12.

Eventually, I_{C} reaches a current level that is substantially unaffected by further increases in V_{CE}, and this current level is the desaturation current level 22a), 22b), 22c). Respective desaturation current levels 22a), 22b), 22c) associated with each of the aforementioned gate-emitter voltage profiles 20a), 20b), 20c) are shown in Figure 2.

It can be seen from Figure 2 that the desaturation current level 22a) of an IGBT 12 being operated at a gate-emitter voltage V_{GE} equal to the industry-standard 15V, i.e. voltage profile 20a), is around 4 times its rated current I_{RATED}. Meanwhile, the desaturation current level 22c) of an IGBT 12 being operated at a gate-emitter voltage V_{GE} equal to 25V, i.e. voltage profile 20c), is around 8 times its rated current I_{RATED}. Accordingly, with a small increase in gate-emitter voltage V_{GE} of the IGBT 12, the desaturation current level 22c) can be doubled.

As such, the IGBT 12 being operated at a gate-emitter voltage V_{GE} higher than the industry standard control voltage can permit a higher collector-emitter current I_{C} to flow through the IGBT 12 without the IGBT 12 entering the desaturated state.

It can be seen from Figure 2 that, when the IGBT 12 is operated at its rated current I_{RATED}, a lower collector-emitter voltage V_{CE} is required as the gate-emitter voltage V_{GE} is increased. The conduction losses associated with the IGBT 12 are equal to the collector-emitter current I_{C} multiplied by the collector-emitter voltage across the device V_{CE}. Therefore, the conduction losses are reduced when the IGBT 12 is operated at a gate-emitter voltage V_{GE} above the industry-standard control voltage (i.e. above 15V in the examples shown in Figure 2).

Since the IGBT 12 being operated at a gate-emitter voltage V_{GE} higher than the industry standard control voltage results in a higher collector-emitter current I_{C} to flow through the IGBT 12 without the IGBT 12 entering the desaturated state, the IGBT 12 must be protected from an elevated collector-emitter current I_{C} which is below the saturation current level 22b), 22c) but which can still damage the IGBT 12.

For the purposes of describing the working of the invention, the IGBT 12 is considered to be operated at a gate-emitter voltage V_{GE} equal to 25V, but it will be appreciated that the IGBT 12 may instead be operated at any other gate-emitter voltage V_{GE} greater than the industry standard control voltage.

Returning to the method of the invention, the collector-emitter current I_{C} is monitored while the IGBT 12 is in the saturated state.

In the event of a fault, the collector-emitter current I_{C} will rise in magnitude due to a fault current. The IGBT 12 is turned off when the collector-emitter current I_{CE} exceeds a safety current threshold I_{S} and before the collector-emitter current I_{C} reaches a current level which allows the IGBT to enter the desaturated state, i.e. before it reaches the desaturation current level 22c).

As such, the IGBT 12 is turned off before it enters the desaturated state and before the collector-emitter current I_{C} reaches a level which may damage the IGBT 12.

A reverse bias safe operating area (RBSOA) is defined for IGBTs under repetitive switching conditions, as shown in Figure 6. This typically includes collector-emitter currents I_{C} up to twice a continuously-rated rated value. The safety current threshold I_{S} will normally be chosen to be above rated current I_{RATED} of the IGBT 12 but within the RBSOA, taking into account how much the collector-emitter current I_{C} might increase between detection of the collector-emitter current I_{CE} above the current threshold I_{S} and turn off of the IGBT being enacted. A typically value might be 85 % of the RBSOA or 1.7 times the rated current I_{RATED}.

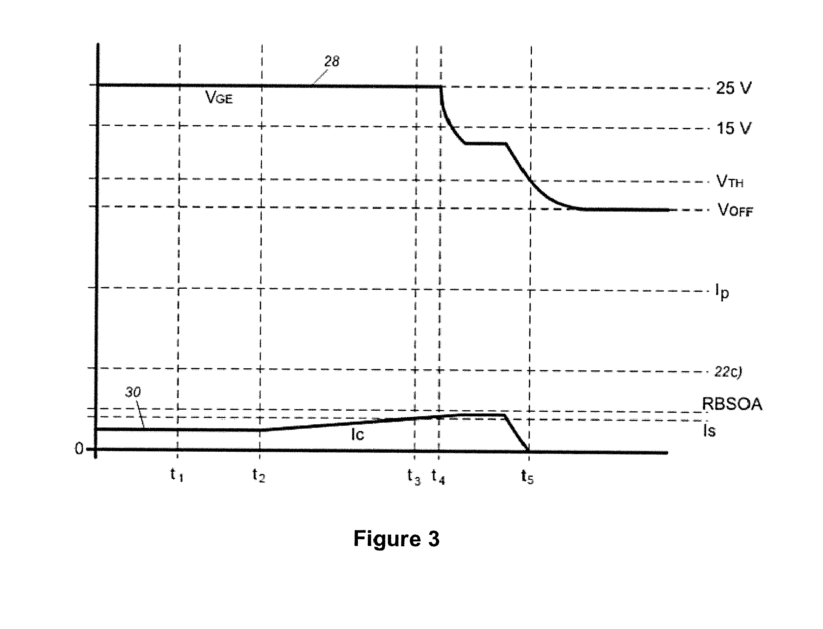

Figure 3 shows a gate-emitter voltage profile 28 and a collector-emitter current profile 30 of the IGBT 12 in the event of a fault.

At time t₁, the IGBT 12 is fully on in its saturated state. The gate-emitter voltage V_{GE} is 25V and the collector-emitter current I_{C} is at its rated current I_{RATED}.

At time t₂ a fault occurs and a fault current causes the collector-emitter current I_{C} to rise towards a peak current I_{P}. The peak current I_{P} is much higher, for example 20 times higher, than the desaturation current level 22c), such that if the IGBT 12 is left in its saturated state, the IGBT 12 would eventually enter the desaturated state. In other embodiments of the invention (not shown), the peak current I_{P} may be lower than the desaturation current level 22c).

Before reaching the peak current I_{P}, the collector-emitter current I_{C} reaches and exceeds the safety current threshold I_{S} at time t₃.

The IGBT 12 is turned off in direct response to the collector-emitter current I_{C} exceeding the safety current threshold Is, i.e. the IGBT 12 is turned off at time t₃. Moreover, the IGBT 12 is turned off when the collector-emitter current I_{C} is rising in magnitude towards the peak current I_{P}.

It will be understood that there may be a small delay, for example of a couple of microseconds, from the detection of the collector-emitter current I_{C} exceeding the safety current threshold I_{S} and the IGBT 12 being turned off due to delays in the control for turning the IGBT 12 off.

After time t₄, the gate-emitter voltage V_{GE} begins to fall towards zero. As the gate-emitter voltage V_{GE} falls, rise of the collector-emitter current I_{C} is halted followed by it being reduced to zero at time t₅. Once the gate-emitter voltage V_{GE} reaches a conduction threshold voltage V_{TH}, i.e. at time t₅, the IGBT 12 is considered fully off. The time delay between time t₃ and t₅ is around 4µs. The gate-emitter voltage V_{GE} is further reduced to an off-voltage V_{OFF} which may be between -10V and -15V. The off-voltage V_{OFF} ensures that any spikes of voltage, for example that may be applied across the gate terminal 14 of the IGBT 12 due to electrical noise, do not result in inadvertent turning on of the IGBT 12.

The IGBT 12 is therefore turned off before the collector-emitter current I_{C} reaches a current level which allows the IGBT 12 to enter the desaturated state, i.e. before the collector-emitter current I_{C} reaches the desaturation current.

The collector-emitter current I_{C} is monitored by monitoring the collector-emitter voltage V_{CE} when the IGBT 12 is in the saturated state. In this regard, the collector-emitter voltage V_{CE} is monitored for exceeding a safety voltage threshold (not shown) that is indicative of the safety current threshold Is.

In other embodiments of the invention (not shown), the collector-emitter current I_{C} may instead be monitored by monitoring the voltage across a resistor connected in series with the IGBT 12 as a shunt or by sensing a magnetic field generated by the collector-emitter current I_{C} of the IGBT 12.

In the embodiment shown, the collector-emitter current I_{C} exceeding the safety current threshold I_{S} is caused by a fault that occurs external to an electrical module (not shown) containing the IGBT 12, for example a fault caused by a lightning strike. The collector-emitter current I_{C} exceeding the safety current threshold I_{S} may instead be caused by a fault that occurs internal to the electrical module containing the IGBT 12.

Such an external fault has a higher associated impedance than that of an internal fault. As such, the rate of change of the collector-emitter current I_{C} is lower than that of an internal fault, thus providing enough time for the IGBT 12 to be turned off before the collector-emitter current I_{C} reaches either a level that may result in the IGBT 12 being damaged, or the desaturation level 22c).

However, some internal faults may result in a rate of change of collector-emitter current I_{C} that does not provide enough time for the IGBT 12 to be turned off safely. Thus the protection method of the invention may not protect against some internal faults but this may be acceptable in embodiments where the electrical module forms part of a modular multi-level converter with redundant levels and the ability to bypass damaged electrical modules so that operation of the remaining electrical modules can continue uninterrupted.

Optionally the IGBT 12 may be turned on at a first gate-emitter voltage V_{GE} (e.g. 15V) that is lower than the desired gate-emitter voltage V_{GE} for operating the IGBT 12 in a saturated state. The collector current I_{C} or the collector-emitter voltage V_{CE} of the IGBT 12 is then monitored for a predefined time period, e.g. 10 µs, to determine whether the IGBT 12 at the first gate-emitter voltage V_{GE} enters a desaturated state. After the predefined time period lapses, the gate-emitter voltage V_{GE} of the IGBT 12 is then increased from 15 V to a higher, second control voltage gate-emitter voltage V_{GE} (e.g. 25V) in order to thereby carry out the step of operating the IGBT 12 in the saturated state.

The initial turn-on of the IGBT 12 at the first gate-emitter voltage V_{GE} allows the IGBT 12 to enter a desaturated state to limit any fault current flowing therethrough, in the event that a short-circuit is established upon the turn-on of the IGBT 12. Thereafter, if the short-circuit has not occurred, increasing the gate-emitter voltage V_{GE} allows the IGBT 12 to be operated in the saturated state at the higher, second gate-emitter voltage V_{GE}. Thereafter, the IGBT 12 is protected by way of the aforementioned turn-off of the IGBT 12 such that the IGBT 12 does not enter the desaturated state before it is turned off.

Further optionally, the collector current I_{C} or the collector-emitter voltage V_{CE} of the IGBT 12 may be monitored to detect whether the IGBT 12 has entered a desaturated state.

This is useful in circumstances (e.g. an internal fault) where the fault current rises too quickly such that it is not possible to turn-off the IGBT 12 such that the IGBT 12 does not enter the desaturated state before it is turned off. Under such circumstances, the IGBT 12 may enter the desaturated state.

When the IGBT 12 enters the desaturated state, the detection of the IGBT 12 entering the desaturated state can be used as a trigger to initiate other protection mechanisms, such as closure of an associated bypass switch. Whilst this does not guarantee the safety of the IGBT 12, other associated devices may be protected by the initiation of the other protection mechanisms.

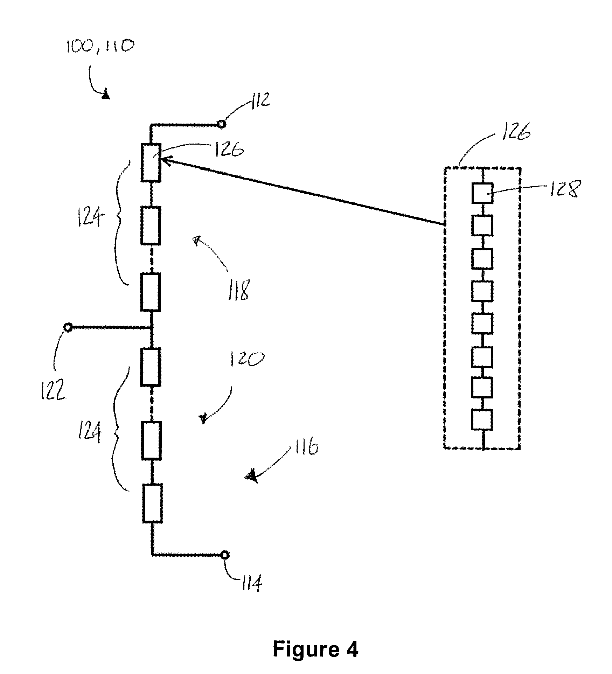

An electrical assembly 100 is shown in Figure 4.

The electrical assembly 100 is a voltage source converter 110 which includes first and second direct current (DC) terminals 112, 114 between which extends a converter limb 116. Other voltage source converters may include more than one converter limb 116 and, in particular, may include three converter limbs, each of which corresponds to a given phase of a three-phase electrical power system.

The converter limb 116 includes first and second limb portions 118, 120 which are separated by an alternating current (AC) terminal 122.

In use the first and second DC terminals 112, 114 are respectively connected to positive and negative terminals of a DC network, and the AC terminal 122 is connected to an AC network.

Each limb portion 118, 120 includes a chain-link converter 124 which extends between the AC terminal 122 and a corresponding one of the first or the second DC terminal 112, 114. Each chain-link converter 124 includes a plurality of series connected chain-link modules 126, and each chain-link module 126 in turn includes a plurality of, e.g. eight, series connected sub-modules 128.

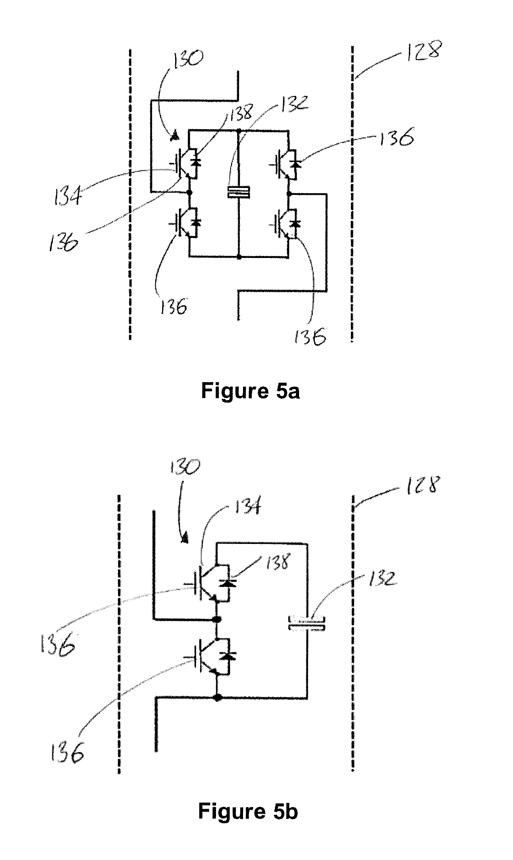

Each sub-module 128 includes a number of switching elements 130 which are connected in parallel with an energy storage device in the form of a capacitor 132, as shown in Figures 5a) and 5b). In the arrangements shown each switching element 130 includes a semiconductor device 134 in the form of an IGBT 136. The IGBT 136 is connected in anti-parallel with a diode 138.

The IGBT 136 shares the same features as the IGBT 12 described hereinabove.

Figure 5a) shows a sub-module 128 in a known full bridge arrangement so as to define a 4-quadrant bipolar module, while Figure 5b) shows a sub-module 128 in a known half-bridge arrangement so as to define a 2-quadrant unipolar module.

Through operation of the sub-modules 128, it is possible to build up a combined voltage across each chain-link converter 124 by combining the individual voltages available from the chain-link modules 126.

For successful operation of the voltage source converter 110 it is often necessary for each chain-link converter 124 to include several hundred chain-link modules 26 and, in turn, typically several thousand sub-modules 128. As such, the voltage source converter 110 typically includes several thousand IGBTs 136.

During normal operation of the voltage source converter 110, each of the IGBTs 136 is operated in either a saturated state or a blocked state. Operation of the IGBTs 136 in the saturated state is identical to operation of the IGBT 12 as described hereinabove in the saturated state.

The collector-emitter current I_{C} of each of the IGBTs 136 is monitored when the IGBTs 136 are in the saturated state.

In the event of a fault, the collector-emitter current I_{C} of at least one IGBT 136 will rise due to a fault current. At least one of the IGBTs 136 is turned off when the collector-emitter current I_{C} of the or each IGBT 136 exceeds a safety current threshold I_{S} and before the collector-emitter current I_{C} of the or each IGBT 136 reaches a current level which allows the or each IGBT 136 to enter the desaturated state, i.e. before it reaches the desaturation current level 22c).

As such, the or each IGBT 136 is turned off before it enters the desaturated state and before the collector-emitter current I_{C} reaches a level which may damage the or each IGBT 136.

Each of the IGBTs 136 of the voltage source converter 110 may be turned off in the event of a fault. Instead, a select number of IGBTs 136 of the voltage source converter 110, for example the IGBTs 136 belonging to a particular sub-module 128 or particular chain-link module 126, may be turned off in the event of a fault.

In addition, in the event of a fault, a select number of IGBTs 136 of the voltage source converter 110 may be turned off before they enter the desaturated state, while the remaining IGBTs 136 of the voltage source converter 110 may be allowed to reach the desaturation current level 22a) such that the remaining IGBTs 136 enter the desaturated state.

In this way, the remaining IGBTs 136 of the voltage source converter 110 are protected from the fault current by the desaturated state of the remaining IGBTs 136 reducing the collector-emitter current I_{C} while the select number of IGBTs 136 of the voltage source converter 110 are protected from the fault current by being turned off before the select number of IGBTs 136 enter the desaturated state.

The remaining IGBTs are operated at a gate-emitter voltage V_{GE} equal to 15V, and thus experience a higher conduction loss than the select number of IGBTs that are operated at a gate-emitter voltage V_{GE} equal to 25V.

The IGBTs 136 located at the top of each sub-module 128 of the voltage source converter 110 have a lower current flowing therethrough than the other IGBTs 136 belonging to each sub-module 128, and so the top IGBTs 136 can be protected from a fault current by allowing the top IGBTs 136 to enter the desaturated state. Since the top IGBTs 136 belonging to each sub-module 128 have a lower current flowing therethrough, they naturally have less conduction losses associated with them. Thus, the top IGBTs 136 belonging to each sub-module 128 can be operated at a gate-emitter voltage V_{GE} equal to 15V with a minimal detrimental effect to the overall conduction losses of the voltage source converter 110.

Meanwhile, the remaining (i.e. bottom) IGBTs 136 belonging to each sub-module 128 have a higher current flowing therethrough than the top IGBTs 136 belonging to each sub-module 128, and so the bottom IGBTs 136 are protected from a fault current by turning off the bottom IGBTs 136 before the bottom IGBTs 136 enter the desaturated state. This is possible because fast-rising internal sub-module fault currents are limited by the top IGBTs 136 desaturating while fault currents external to the sub-module 128 are rising slowly enough for the bottom IGBTs 136 to take effective action alone. Since the bottom IGBTs 136 belonging to each sub-module 128 have a higher current flowing therethrough, they naturally have more conduction losses associated with them. Therefore the bottom IGBTs 136 belonging to each sub-module 128 can be operated at a gate-emitter voltage V_{GE} equal to 25V so as to reduce the conduction losses of the limb portions 118, 120, thereby reducing the overall conduction losses of the voltage source converter 110.

This foregoing two paragraphs assume, for the full bridge arrangement shown in Figure 5a, that the bypass or zero-volt state is achieved by conduction of the bottom IGBTs 136. In respect of the foregoing two paragraphs and the full bridge arrangement of Figure 5a, it is possible to reverse the references to top and bottom devices.

It will be appreciated that the voltage source converter 110 described hereinabove is for illustration purposes and that other electrical assemblies fall within the scope of the invention.

A semiconductor device protection apparatus 200 according to a second embodiment of the invention is also shown in Figure 1.

The semiconductor device protection apparatus 200 includes the semiconductor device 10, i.e. the IGBT 12, described hereinabove in relation to the first embodiment of the invention.

The semiconductor device protection apparatus 200 also includes a control unit 210 that is configured to operate the IGBT 12 in the saturated state.

The semiconductor device protection apparatus 200 further includes a monitoring device 220 that is in communication with the control unit 210. The monitoring device 220 is configured to monitor the collector-emitter current I_{C} of the IGBT 12, and communicate the monitored current to the control unit 210.

The control unit 210 is further configured to turn off the IGBT 12 when the collector-emitter current I_{C} exceeds the safety current threshold I_{S} and before the collector-emitter current I_{C} reaches a current level which allows the IGBT 12 to enter the desaturated state, i.e. before the desaturation current level 22c).

In other embodiments of the invention (not shown), the control unit 210 and monitoring device 220 may form part of the same unit.

A similar semiconductor device protection apparatus 200 is used in conjunction with the IGBTs 136 belonging to the voltage source converter 110 shown in Figures 4, 5a) and 5b) so as to form a protection apparatus according to the first embodiment of the invention.

The semiconductor device protection apparatus 200 is not shown in Figures 4, 5a) or 5b) for clarity purposes.

It will however be appreciated that the control unit 210 is configured to operate each of the IGBTs 136 in the saturated state. Meanwhile the monitoring device 220 is configured to monitor the collector-emitter current I_{C} of each IGBT 136 and communicate the monitored current to the control unit 210.

The control unit 210 is further configured to turn off at least one of the IGBTs 136 when the collector-emitter current I_{C} exceeds the safety current threshold I_{S} and before the collector-emitter current I_{C} reaches a current level which allows the or each IGBT 136 to enter the desaturated state, i.e. before the desaturation current level 22c).

In a further embodiment, the monitoring device 220 may measure a current on one of the sub-module 128 output connections from which the control unit 210 infers the collector-emitter current I_{C} of each IGBT 136.

## Claims

1. A method of protecting at least one semiconductor device from a fault current that exceeds a safety current threshold, the method comprising the steps of:
operating the or each semiconductor device in a saturated state;
monitoring a current through the or each semiconductor device in the saturated state;
turning off the or each semiconductor device from the saturated state when the current through the or each semiconductor device exceeds the safety current threshold and before the current through the or each semiconductor device reaches a current level which allows the or each semiconductor device to enter a desaturated state.

2. A method according to Claim 1 wherein the step of turning off the or each semiconductor device is carried out in direct response to the current through the or each semiconductor device exceeding the safety current threshold.

3. A method according to Claim 1 or Claim 2 wherein the step of turning off the or each semiconductor device is carried out when the current through the or each semiconductor device is rising in magnitude.

4. A method according to any preceding claim wherein operating the or each semiconductor device in a saturated state includes operating the or each semiconductor device at a control voltage above that at which a short-circuit safe operating area of the semiconductor device is defined.

5. A method according to any preceding claim wherein operating the or each semiconductor device in a saturated state includes operating the or each semiconductor device in the form of an insulated-gate bipolar transistor at a control voltage above 15V.

6. A method according to any preceding claim wherein monitoring a current through the or each semiconductor device includes monitoring one or more of:
a saturated voltage drop across the or each semiconductor device;
a voltage drop across a resistor connected in series with the or each semiconductor device as a shunt; or
a magnetic field generated by the current through the or each semiconductor device.

7. A method according to any preceding claim wherein the or each semiconductor device includes a gate terminal, a collector terminal and an emitter terminal, and optionally wherein the or each semiconductor device is an insulated-gate bipolar transistor.

8. A method according to Claim 7 wherein the or each semiconductor device is operated in the saturated mode at a control voltage, the control voltage in the form of a gate-emitter voltage applied across the gate and emitter terminals of the or each semiconductor device.

9. A method according to any preceding claim wherein the or each semiconductor device forms part of an electrical module, and wherein the current through the or each semiconductor device exceeding the safety current threshold is caused by a fault that occurs external to the electrical module.

10. A method according to any preceding claim further including the steps of:
turning on the or each semiconductor device at a first control voltage;
monitoring a current through or a voltage across the or each semiconductor device for a predefined time period to determine whether the or each semiconductor device at the first control voltage enters a desaturated state;
after the predefined time period lapses, increasing the control voltage of the or each semiconductor device from the first control voltage to a higher, second control voltage in order to thereby carry out the step of operating the or each semiconductor device in a saturated state.

11. A method according to any preceding claim further including the step of monitoring a current through or a voltage across the or each semiconductor device to detect whether the or each semiconductor device has entered a desaturated state.

12. A method according to any preceding claim including the steps of:
operating each of a plurality of semiconductor devices in a saturated state;
monitoring a current through each of the plurality of semiconductor devices in the saturated state;
turning off at least one of the plurality of semiconductor devices from the saturated state when the current through the or each semiconductor device exceeds the safety current threshold and before the current through the at least one semiconductor device reaches a current level which allows the at least one semiconductor device to enter a desaturated state.

13. A method according to Claim 12 including the step of allowing the current through at least one other of the plurality of semiconductor devices to reach a current level which allows the or each other semiconductor device to enter the desaturated state.

14. A semiconductor device protection apparatus comprising:
at least one semiconductor device;
a control unit being configured to operate the or each semiconductor device in a saturated state; and
a monitoring device being in communication with the control unit, the monitoring device being configured to monitor a current through the or each semiconductor device in the saturated state and communicate the monitored current to the control unit,
wherein the control unit is further configured to turn off the or each semiconductor device from the saturated state when the current through the or each semiconductor device exceeds a safety current threshold and before the current through the or each semiconductor device reaches a current level which allows the or each semiconductor device to enter a desaturated state.

15. A semiconductor device protection apparatus according to Claim 14 including:
a plurality of semiconductor devices;
a control unit being configured to operate each of the plurality of semiconductor devices in a saturated state; and
a monitoring device being in communication with the control unit, the monitoring device being configured to monitor a current through each of the plurality of semiconductor devices in the saturated state and communicate the monitored current to the control unit,
wherein the control unit is further configured to turn off at least one of the plurality of semiconductor devices from the saturated state when the current through the at least one semiconductor device exceeds a safety current threshold and before the current through the at least one semiconductor device reaches a current level which allows the at least one semiconductor device to enter a desaturated state.

16. A semiconductor device protection apparatus according to Claim 15 wherein the control unit is additionally configured to allow the current through at least one other of the plurality of semiconductor devices in the saturated state to reach a current level which allows the or each other semiconductor device to enter the desaturated state.
